Europäisches Patentamt

(19) European Patent Office

Office européen des brevets

(11) Publication number: **0 087 776**
**B1**

(12) **EUROPEAN PATENT SPECIFICATION**

(45) Date of publication of patent specification: **10.06.87**

(51) Int. Cl.⁴: **H 01 L 31/18**, G 01 R 31/26

(21) Application number: **83101862.7**

(22) Date of filing: **25.02.83**

(54) Method and apparatus for increasing the durability and yield of thin film photovoltaic devices.

(30) Priority: **25.02.82 US 352218**

(43) Date of publication of application:
**07.09.83 Bulletin 83/36**

(45) Publication of the grant of the patent:
**10.06.87 Bulletin 87/24**

(84) Designated Contracting States:
**DE FR GB**

(73) Proprietor: **University of Delaware**
**101 Hullihen Hall**
**Newark Delaware 19711 (US)**

(72) Inventor: **Phillips, James E.**
**112 Elliot Street**
**Newark Delaware 19713 (US)**
Inventor: **Lasswell, Patrick G.**
**82 Hobart Drive Apartment 5D4**
**Newark Delaware 19713 (US)**

(74) Representative: **Abitz, Walter, Dr.-Ing. et al**
**Abitz, Morf, Gritschneder, Freiherr von**
**Wittgenstein Postfach 86 01 09**
**D-8000 München 86 (DE)**

(56) References cited:

IBM TECHNICAL DISCLOSURE BULLETIN, vol. 19, no. 4, September 1976, pages 1457-1458, New York, USA J.P. HOEKSTRA: "Testing a multilevel line structure for shorts"

OPTICS & LASER TECHNOLOGY, vol. 12, no. 6, December 1980, pages 317-320, Exeter, G.B. "Automatic inspection of silicon wafers"

(56) References cited:

IEEE TRANSACTIONS ON ELECTRON DEVICES, vol. ED-27, no. 4, April 1980, pages 864-872, New York, USA D.E. SAWYER et al.: "Laser scanning of solar cells for the display of cell operating characteristics and detection of cell defects"

IBM TECHNICAL DISCLOSURE BULLETIN, vol. 24, no. 11B, April 1982, page 6027, New York, USA S.M. SALEEM et al.: "Contactless electrical isolation detector"

Courier Press, Leamington Spa, England.

## Description

### Background of invention

Thin film photovoltaic cells or devices generally include an opaque electrical contact which serves as a substrate upon which a first semiconductor layer is applied. A second semiconductor layer is then formed or applied to the first semiconductor layer with an electrical junction formed therebetween. Finally, a second electrical contact is applied to the second semiconductor layer. Such structure involves the basic components of a thin film photovoltaic cell. Numerous variations including the manner of forming the various layers, the materials, etc. are known and practiced in the art. For example, one such practice involves cadmium sulfide and copper sulfide semiconductor layers. Other semiconductor materials include amorphous silicon and zinc phosphide. Additionally such cells have been formed by using, for example, copper indium on cadmium sulfide or zinc cadmium sulfide. In order for such photovoltaic devices to have the desired durability and yield, the semiconductor layers should be free of defects which might otherwise cause shorts. For example, commonly assigned US—A—4,251,286 discusses the possible electrical shorts that may result in such cells. Such patent attempts to avoid such shorts by providing blocking layer material where necessary to prevent the undesired contact between non-adjacent layers.

It would be desirable to avoid such electrical shorts in other manners than described in the aforesaid patent.

In IEEE Transactions on Electron Devices, Vol. ED-27, No. 4, April 1980, pages 864—872, a method is described for scanning one layer of a solar cell, e.g. a thin film silicon cell, with a laser beam in order to detect the location of cell defects such as cracks. Such defects can lead to shunting leakage currents. However, there is no method described to selectively eliminate these defects following the step of locating these defects.

### Summary of invention

The invention provides a method of manufacturing thin film photovoltaic cells wherein an electrical junction is formed between a pair of semiconductor layers mounted on a substrate with one of the semiconductor layers being adjacent the substrate and the other layer being remote from the substrate, a bias voltage being applied between the semiconductor layers, and wherein one of the semiconductor layers is laser scanned to locate any defects therein whereby a conductive contact provided on one side of that semiconductor layer would contact the other semiconductor layer through the defect which would result in a short, the defects being located by relating the x—y coordinate of the laser beam impact on the scanned semiconductor layer with the light-generated current flowing through the cell, which is characterized in that the applied bias voltage is a reverse bias voltage and that the defect causing such shorting is selectively eliminated by thermally burning out the defect.

The invention further provides an apparatus for the continuous manufacture of thin film photovoltaic cells according to the above described method wherein the apparatus includes a plurality of sequentially arranged stations for providing a substrate which functions as an opaque electrical contact, for applying a first semiconductor layer to the substrate, for applying a second semiconductor layer to the first semiconductor layer, for applying a bias voltage between the semiconductor layers, for selectively detecting shorting defects by laser scanning means and for applying a transparent electrical ·contact to the second semiconductor layer, which is characterized in that the bias ·voltage applying station is designed to apply reverse bias voltage and that the station for selectively detecting shorting defects includes thermal application means to selectively eliminate shorting defects by burning out.

In accordance with this invention, the layers are scanned in such a manner to precisely locate a potential shorting defect. By so locating the defect, it is possible to remove the defect itself thus obviating the need for applying any special added material to function, for example, as a blocking layer. Furthermore, locating and eliminating shunting defects is accomplished during the manufacture of a photovoltaic device, before final application of a second electrical contact.

In accordance with the invention a laser is used for scanning the semiconductor layer in association with a display screen which would indicate the detection of a defect. The display screen would correspond by the xy coordinate system to the semiconductor layer being scanned so that the precise location of the defect would be known and thus it could be eliminated. One manner of eliminating the defect would be by the use of an electrically conductive wire applied thereto. In the preferred practice of the invention, however, the same laser equipment used for locating the defect is also used to eliminate it. This could be done by scanning the semiconductor when the laser equipment is operating under its low power mode and then eliminating the defect when the laser equipment is under its high power mode.

The invention and particularly the use of the laser equipment lends itself for incorporation in a system wherein a plurality of stations are arranged seriatum for the continuous manufacture of thin film photovoltaic devices.

### The drawings

Figure 1 is a cross-sectional view in elevation of a typical thin film semiconductor layer structure with which the invention deals;

Figure 2 is a block diagram schematically showing the scanning of a thin film photovoltaic semiconductor in accordance with this invention;

Figure 3 illustrates a typical line pattern that would be produced on the display screen of Figure 1 when a defect is detected;

Figure 4 is a perspective view showing the application of the laser contacts to the components of an incomplete photovoltaic device in accordance with this invention;

Figure 5 is a schematic diagram showing the location of a scanning and defect elimination station in an arrangement for the continuous manufacture of thin film photovoltaic devices;

Figure 6 is a detailed schematic diagram of the scanning and defect elimination station of Figure 5;

Figure 7 is an inverted view of the station of Figure 6;

Figure 8 is a schematic block diagram of the steps comprising manufacture of a $Cu_2S/CdS$ cell with improved stability;

Figure 9 is a schematic diagram of a scanning and defect elimination station in the manufacture of thin film photovoltaic devices on non-conductive substrates; and

Figure 10 is a further form of device with which the invention deals.

Detailed description

The present invention is directed to thin film photovoltaic devices which are essentially free of shorts and shunts. Shunts and short circuits are well known to reduce the energy conversion efficiency of photovoltaic devices. Since large areas of photovoltaic devices must be manufactured and deployed at low cost if such devices are to be useful for practical generation of electricity, the incidence of shorts and shunts reduces production yield and increases cost. Furthermore, certain types of shunts, such as, for example, in photovoltaic devices comprising copper sulfide as one of its semiconductor layers, cause rapid degradation of efficiency upon deployment, even when the initial magnitude of the shunt resistance is too high to be significant in an initial test of the efficiency of a photovoltaic device. Such shunts are the result of a variety of defects in the semiconductor layers of a thin film photovoltaic device such as pinholes, cracks, inclusions and the like. Applicants have recognized that although thin film semiconductor layers for photovoltaic devices may be characterized by many such defects, not all defects are associated with shunting and short circuiting. The present invention is directed to the detecting of the location of a shunting defect in thin film semiconductor layers and, upon such detection, of the elimination of such shunting defect so as to provide a means for producing thin photovoltaic devices having increased efficiency, manufacturing yield and reliability.

According to the invention, a laser scanner is employed. Laser scanners have previously been used in connection with thin film photovoltaic devices. Such prior art uses, however, have generally been in order to survey completed devices to determine, for example, cosmetic imperfections, response uniformity and imperfections in contact metallization, and generally not for scanning incomplete cells during the process of manufacture. Such prior art uses are, furthermore, confined to completed cells so that shunting defects which are covered by contact metallizations, grid lines or other types of transparent contacts cannot be detected and eliminated without damaging the cell device.

The present invention includes as its novelty the use of such scanning equipment, in general, and laser scanners, in particular, in the manner set forth hereinafter, but such laser equipment, per se, and even with thin film photovoltaic cells, is not asserted to be novel. For example, NBS Special Publication 400-24, February 1977 by Sawyer and Berning describes a laser scanner for semiconductive devices. Further descriptions of laser scanners are also found in IEEE Transactions on Electron Devices, Vol. ED-27, No. 4, April 1980, pp. 864—872; Solid State Electronics Vol. 23, pp. 565—576, 1979; Proc. SPIE 24th Annual Int's. Technical Symposium Vol. 248, pp. 142—147, 1980; Photovoltaic Specialists Conference, pp. 1021—1024, 1981; US—A—4,205,265; Quarterly reports to SERI under Subcontract No. XJ-9-8254 prepared by Carlson et al and dated January, April and December 1979; N. C. Wyeth, "Optical Spot Scanning of $Cu_2S$-CdS Cells", International Workshop on Cadmium Sulfide Solar Cells and Other Abrupt Heterojunctions, April 30—May 2, 1975, University of Delaware, pp. 575—583; Proceedings of SERI Subcontractors Review Meeting, Washington, D.C., September 3—5, 1980; "Aspects of $Cu_xS$-CdS Solar Cells", April 30—May 2, 1975, University of Delaware, pp. 268—269; Mostek (Div. of UTC). Electronic Design, September 30, 1981, pp. 104—105; NBS report NBSIR 81-2260 to SERI dated May 1981; and US—A—4,197,141. The invention departs from the state of the art by recognizing that such laser equipment can be used for detecting the precise location of shunting defects and then eliminating such defects. In view of the state of the art, however, a detailed description of suitable laser equipment herein is not necessary except as it specifically applies to the practice of the invention.

Generally, complete thin film photovoltaic devices or cells include as the transparent electrical contact a component which is either in grid form or which may be a complete continuous layer. The invention is practiced with the use of a laser by applying temporary contacts to one semiconductor layer and completing the electrical circuit by connecting to the ohmic electrical contact of the other semiconductor layer. A display screen indicates by a straight line where there is no defect, but an irregularity in the line results on the display screen where there is a shunting defect to thereby clearly indicate the precise location of that defect.

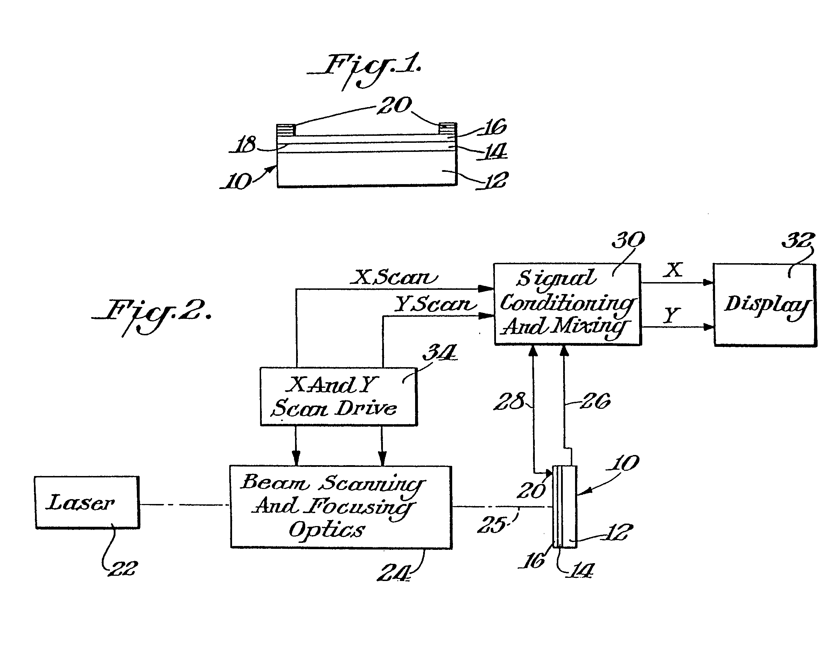

Figure 1 illustrates typical thin film semiconductor layers of a photovoltaic structure which, in accordance with the invention, would be scanned to locate shunting defects and the shunting defects would be eliminated. As indicated therein, structure 10 includes a substrate 12 which comprises an ohmic electrical contact.

A first semiconductor layer 14 is formed on or placed in contact with substrate 12 such that ohmic contact is made. If substrate 12 is a conductor such as a metal foil or graphite sheet on a heavily doped semiconductor such as impure silicon sheet, the exposed portions of substrate 12 not in contact with and opposite layer 14 are used for connecting to an electrical circuit. When the body of substrate 12 is an insulator or poor conductor such as glass, ceramic, polymer film, mica and the like, means which are apparent to those skilled in the semiconductor art must be incorporated to the structure so as to provide electrical connection to layer 14 via the ohmic contact inherent in substrate 12.

A second semiconductor layer 16 is formed on the semiconductor layer 14. Layer 16 may also be an oppositely doped region of layer 14. In either case, a rectifying junction 18 is located between layers 14 and 16. Electrical contact to layer 16 in accordance with this invention is provided by temporary contact means 20.

Examples of particular semiconductor layers and the photovoltaic devices to which they relate are as follows: $Cu_2S$/CdS where substrate 12 is zinc plated copper foil or tin oxide coated glass, layer 14 is CdS or more specifically $(Zn_xCd_{1-x})S$ where $0 \leq x \leq 0.3$, and a layer 16 is $Cu_2S$; CuInSe/ CdS where substrate 12 is a metallized ceramic, layer 14 is CuInSe, and layer 16 is CdS or $(Zn_xCd_{1-x})S$; A-Si, where layer 12 is glass upon which has been deposited a conductive oxide such as tin oxide, indium-tin-oxide or metal film or cermet layer, layer 14 a composite of layers of n-type amorphous silicon upon which is formed an undoped i layer of amorphous silicon, and layer 16 is p-type amorphous silicon or silicon carbide or p-type microcrystalline silicon; polysilicon, where layer 12 is a graphite or metal foil, and layers 14 and 16 are oppositely doped layers of polycrystalline silicon.

One of the problems which adversely affect the durability and yield of thin film photovoltaic cell devices is that small defects occur in one of the semiconducting layers whereby undesired electrical contact results between the components of the device which should be spaced from each other. For example, a defect or hole in inner semiconductor layer 14 could result in material from top semiconductor layer 16 making electrical contact with the conducting substrate 12 which would cause localized shorting. Similarly, defects in top semiconducting layer 16 might cause electrical contact between the inner semiconducting layer 14 and the second electrical contacts which must be applied to layer 16 in order to complete a practical photovoltaic device.

In the particular case of photovoltaic cell devices comprising copper sulfide, any low resistance electrical path between copper sulfide and the substrate causes electromigration of copper and ultimate electrochemical decomposition of copper sulfide into, *inter alia*, a nodule or whisker of copper. This electrochemical decomposition of copper sulfide is recognized as one of the principal factors limiting widespread utilization of copper sulfide comprising photovoltaic cell devices. Elimination of shunting defects in accordance with this invention provides a useful means for obtaining $Cu_2S$ comprising photovoltaic cells having increased durability and reliability and which heretofore have been unavailable for utilization in photovoltaic power generation systems.

The present invention detects the location of such defects and then eliminates the defects to thereby increase the durability and yield of the devices. Location and elimination of shunting defects in accordance with this invention do not reduce the efficiency or utility of a photovoltaic cell and, if the practitioner desires, the invention may be practiced on complete photovoltaic cell devices having a permanent and/or integral transparent contact, although this mode is not preferred.

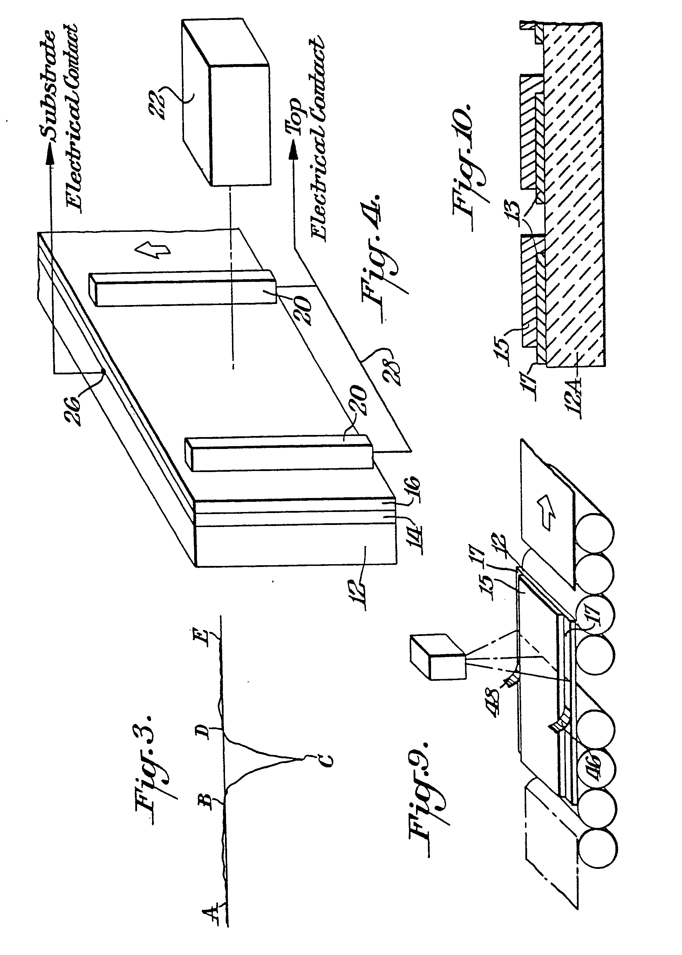

Figure 2 schematically illustrates the use of a laser beam to scan and locate such defects. As indicated therein, the focused laser beam 25 is incident on semiconductor layer 16. The photovoltaic structure is being scanned during a stage of manufacture before a second permanent ohmic electrical contact has been applied to layer 16 to form a complete photovoltaic cell device. In general, electrical connections 26 and 28 are made to substrate 12 and temporary ohmic contact 20, respectively. Connections 26 and 28 are connected to a signal conditioning and mixing device which incorporates means for applying a bias voltage between the semiconductor layers. The polarity of the bias voltage is chosen so as to place rectifying junction 18 (see Figure 1) in the condition known as reverse bias. In general, reverse biasing means that when layer 16 is a p-type semiconductor layer or region and layer 14 is an n-type semiconductor layer or region, layer 16 is at a voltage which is negative with respect to layer 14. When the conductivity types of layers 16 and 14 are n- and p-type, respectively, layer 16 is held at a voltage which is positive with respect to layer 14. The feature of reverse biasing is critical to the practice of the invention. The precise reverse bias voltages to be used in accordance with this invention depend, in general, on the semiconductor materials of layers 14 and 16 and on the sheet resistance of layer 16 and location of temporary contact 20 and on the characteristics of junction 18 in particular. When layer structure 10 is comprised of zinc plated copper foil 12 $(Zn_xCd_{1-x})S$, layer 14, $Cu_2S$, layer 16 and temporary contacts 20 are spaced 1 cm apart, a reverse bias of 0.2 to 0.8 volts has been found to be satisfactory and 0.5 volts most satisfactory. Selection of satisfactory reverse bias conditions for other semiconductor materials and temporary contact configurations would be obvious from the details disclosed herein and below. Also incorporated in the signal conditioning and mixing device 30 are means for detecting current generated in the cell by the action of laser beam 25. This current is commonly referred to as the light generated current of the photovoltaic effect. Laser beam 25 is generated by laser 22 and beam scanning and focusing optics 24. Beam scanning and focusing optics equipment 24 precisely locates the laser beam and focuses the beam to a spot which is, in practice, as small as 2 μm in diameter, although a 30 μm diameter spot has been satisfactory. The selection of laser 22 is governed initially by the wavelength of the emitted radiation. The wavelength must correspond to an energy which is greater than the bandgap of the semiconductor layer which functions as the absorber-generator of a photovoltaic cell device. Since photovoltaic cells which are intended for conversion of sunlight to electricity preferably have at least one semiconductor component with a bandgap less than 1.8 eV, a helium-neon laser emitting 633 nanometer light, corresponding to a photon energy of about 20 eV, is generally suitable. The invention also has application to photovoltaic devices designed to operate with shorter wavelength radiation; however, in those cases, laser 22 must be chosen accordingly.

The exact location of beam 25 on the surface of layer 16 is determined by x and y scan drive 34 acting on the beam scanning component of 24. Electrical signals corresponding to the x and y coordinate positions of beam 25 on the surface of 16 are electrically mixed with conditioned signals corresponding to the light generated current flowing through contacts 26 and 28. Thus, as beam 25 moves first across and then down and then across layer 16 in first the x direction, then the y and then x, the light generated current at a particular x and y coordinate position may be recorded and displayed on screen 32. Coordinates x and y and the corresponding light generated current may be displayed on a cathode ray screen to create a spatial image of the current being generated in the semiconductor layers. The electrical signals generating the display image may also be digitized and stored. The stored information may be recalled to reconstruct the display image or, when fed into an appropriately connected microprocessor, be used to automatically direct subsequent processing operations in the manufacture and assembly of photovoltaic devices, components and systems.

The exact components which comprise items 22, 24, 30, 32 and 34 described in relation to Figure 2 are more fully described in the prior art references cited above.

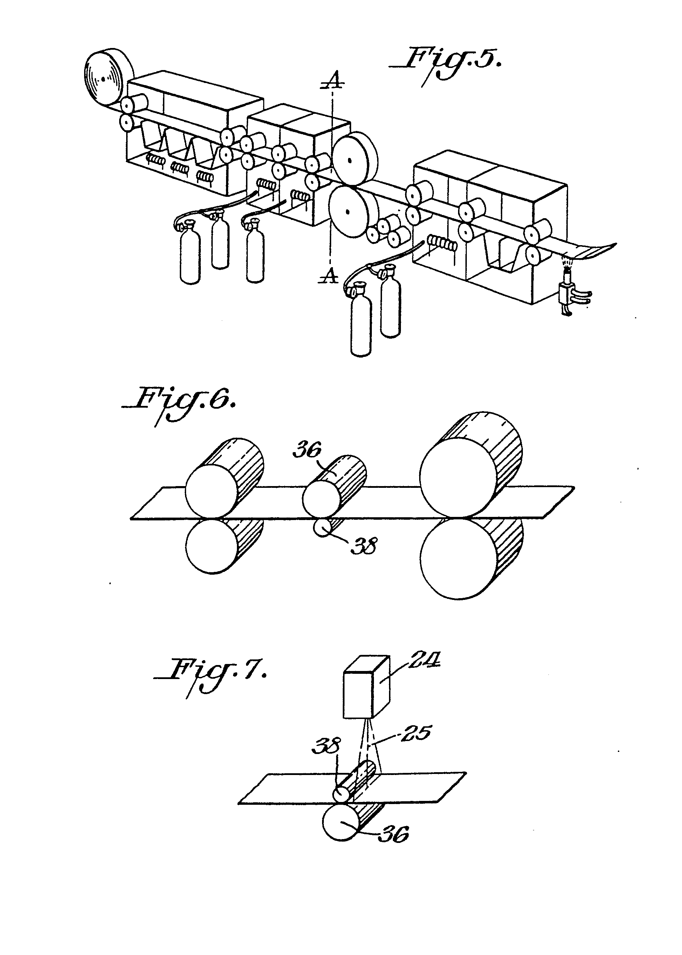

Reference is now made to Figure 3 which shows a typical line pattern which would be displayed on screen 32 during an x movement pass across layer 16. The line pattern of Figure 3 was obtained for a structure of the type where substrate 12 was a zinc plated copper foil; layer 14 was a polycrystalline film of CdS; layer 16 was $Cu_2S$; and contacts 20 are graphite impregnated elastomer bars available from Zebra Stripe Inc.

spaced 1 cm apart on the borders of structure 10. The reverse bias applied via contacts 26 and 28 was 0.5 volts. Where there is no shunting defect in the semiconductor layers, the resulting pattern is a generally straight line as shown between points A and B in Figure 3. Where a defect occurs, however, electrical contact is made between layers 12 and 16 of structure 10 resulting in a pronounced drop or irregularity in the display pattern as indicated by point C. The irregularity thus precisely indicates the location of a shunting defect. As beam 25 continues to move across layer 16 past the defect, a straight line pattern again forms as indicated by points D and E. The shunting defect point C is identified as such by the curvature of the line. If, by way of contrast, there had been simply a hole in layer 16 so that no current was generated at that point, a scan, not shown, would have appeared as a sharp downward spike having a width about equal to the size of the hole and lacking in curvature. The ability to distinguish and precisely locate shunting defects in accordance with this invention depends in part on the aforementioned reverse bias condition. A measure of sufficient reverse bias which the practitioner might use in accordance with this invention is provided by noting that the scan line return points A and E of Figure 3 in the absence of a defect indicated by point C is perfectly horizontal.

The laser scanning of the semiconductor layer thus uses the appropriate wave length to generate a response in the photovoltaic device to locate a short. Upon locating such short, it is then possible to eliminate the defect without chemically processing the semiconductor layers or removing large areas of the semiconductor materials which might otherwise be utilized in a completed photovoltaic device. In one practice of the invention, the defect is burned out by applying any suitable positioned conductive wire at the location of the defect and then applying current through the wire at the position of the defect. Reverse bias of the photovoltaic device reduces the photovoltaic film conductivity in normal areas of the device to a minimum and thus insures that current from the wire flows only through the defect. Upon increasing the current through the wire, the high current density through the defect generates local heating sufficient to burn out the defect. Where the current is applied while the display screen is still on, the elimination of the defect would be apparent by the change of the pattern resulting on display screen 32. In an operative example carried out with a $Cu_2S/CdS/Zn/Cu$ foil structure and the apparatus described above, a gold wire was positioned to touch the $Cu_2S$ at a shunting defect which had been located in accord with this invention. The wire was connected to a DC power supply. After the voltage applied to the wire was increased to about −1.5 volts with respect to the foil substrate, a scan revealed that the shunting defect had been eliminated leaving a negligibly small area, about 0.01 cm² completely inactive. It is contemplated that with greater care the area affected may be reduced by a factor of one thousand.

Although a positioning wire may be used to thermally burn out a defect, the preferred practice of the invention involves the use of the same laser equipment to not only scan and locate the defect but also to eliminate the defect. For example, during the scanning step, the laser equipment would operate at its low power mode of about 1—10 milliwatts. Upon location of the defect, the power would be increased to a high power mode to a magnitude of 1—10 watts which would precisely eliminate a shunting defect or short.

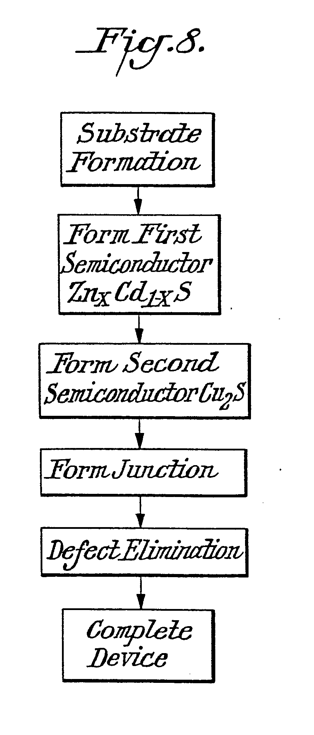

Figure 4 illustrates a segment of a photovoltaic device during the scanning operation in the continuous production of photovoltaic cells as later described. In this embodiment, the contacts are stationary and the material moves relative thereto, while the laser beam is scanned only in the direction perpendicular to the motion of the semiconductor material and substrate, rather than moving the laser in both directions over the semiconductor material as previously described. In both embodiments, however, the laser scan locates defects so that the defects can thereby be eliminated.

As indicated in Figure 4, a single electrical contact 26 is applied to substrate 12. A pair of temporary electrical contacts 20 are applied to top semiconducting layer 16. The p-n junction 18 is reverse biased as previously described. If there is a defect or hole in intermediate semiconducting layer 14, a short will result during scanning which would be indicated by a gradual reduction in current from the photovoltaic material. Such short would visually appear on the screen by the dip C. Upon detecting the defect, the laser output would then be increased at the location in order to remove the defect. When the defect disappears from screen 32, the scanning of the photovoltaic material would continue. Visual detection of a shunting defect and confirmation of its elimination by observing the display screen, while operable, is not preferred for automated manufacturing. As previously described, the location and detection of defects in accordance with this invention may be in the form of digital information suitable for processing by a computer or microprocessor. Such a computerized system can be programmed to recognize defects and direct a high power laser beam to eliminate the defect. Thus it is also within the scope of this invention to employ two lasers, the first a low powered interrogating beam to locate and identify shunting defects and a second high powered laser to remove such defects.

The invention, in its preferred form, is thus particularly advantageous in that it provides for both the detection and elimination of shorting defects in a single step. Moreover, the invention thereby lends itself to application in the continuous thin film photovoltaic manufacturing process as later described. In this regard, electrical contacts 28 are a conductive roller or wiper. The material of the contact should be chosen so as not to damage the semiconductor material as it rubs against the contact roller or wiper. Preferred are contact rollers made from or coated with a conductive elastomer or polymeric coating which has been impregnated with conductive particles. At any rate, material of the wiper or roller should be chosen so as not to damage the semiconductor layer by abrasion, rubbing, cracking and the like. Such contacts would also be suitable where the material is stationary and the contact moves. The laser equipment, as used in this invention could be automated with computer equipment which would monitor the electrical output of the photovoltaic material and automatically increase the laser power when a defect is detected.

Figure 5 illustrates schematically a continuous thin film photovoltaic manufacturing process in which the invention could be incorporated. The general type of operation could be that of the type disclosed in US—A—4,318,938. In general, the process includes a substrate forming operation wherein a web of substrate material would then pass to the semiconductor application station for application of the first semiconductor layer. The composite would then pass to the second semiconductor application station for application of the second semiconductor layer and, if necessary, pass onto a step wherein the junction is formed. At this point the device would correspond to the photovoltaic structure illustrated in Figure 4, and at this point the inventive scanning and defect eliminating step could be provided at line A—A of Figure 5 so as to scan the semiconductor layers and to eliminate shunting defects. Details of the apparatus for locating and eliminating defects in accordance with this invention at location A—A of Figure 5 are schematically shown in Figures 6 and 7. Figure 6 shows contact roller 36 whose function corresponds to contact 26 of Figure 4. Contact roller 38 corresponds to contact 20 of Figure 4 (electrical connections 26 and 28 are not shown in Figure 6). The detail of Figure 7 is inverted from Figure 6 in order to illustrate placement of the beam scanning and focusing optics. Laser beam 25 scans perpendicular to the direction of movement of the photovoltaic structure as previously described in connection with Figure 4. By use of the roller type contacts, the scanning could occur while the composite material is moving to the step comprising application of the second electrical contact.

The invention has been particularly described with respect to semiconductor layers comprising a photovoltaic cell device formed on a metal foil substrate. One such cell is the $Cu_2S/CdS$ type cell which is formed on a zinc plated copper foil or zinc and copper plated iron-nickel sheet. Cells of this type are described in a publication by J. A. Bragagnolo et al which appeared in Transactions of IEEE Electron Devices, Vol. ED-27(4), p. 645 (1980). As previously described, applicants have recognized that shunting defects such as are eliminated in accordance with this invention are the principal cause of degradation in efficiency

and unreliability of $Cu_2S/CdS$ cells. Thus, for example, $CdS/Cu_2S$ cells similar in type to those described in the publication of Bragagnolo et al are known to degrade rapidly in efficiency when placed under continuous illumination of natural sunlight or its equivalent under conditions of forward bias near the maximum power point. In particular, cells exposed under these conditions are found to degrade in a manner characterized by reduction in fill factor and open circuit voltage. This mode of degradation is discussed in the publication of J. Besson et al in the Proceedings of the 11th IEEE Photovoltaics Specialists Conference, pp. 468—475 (1975). Figure 8 schematically illustrates the preparation of $Cu_2S/CdS$ or $Cu_2S/Zn_xCd_{1-x}S$ cells having increased stability. In the first step the substrate is prepared, in the second step a layer of CdS or $(Zn_xCd_{1-x})S$ is formed, in the third step a layer of $Cu_2S$ is formed, in the fourth step the rectifying junction is formed. These steps are carried out by well known procedures such as are described in the paper of Bragagnolo. In the fifth step the inventive apparatus and method described herein are employed to detect and eliminate shunting defects. In the sixth step, the photovoltaic cell is completed by application of a transparent second electrical contact, antireflection coatings and encapsulants. The sixth step also includes intermediate steps comprising heat treatments and application of a blocking layer as taught in U.S. Patent 4,215,286. The invention is also useful in improving the durability, reliability and yield of integrated photovoltaic modules comprising $Cu_2S/CdS$ such as are described in U.S.—A—4,127,424.

It is a particular advantage of this invention that $Cu_2S/CdS$ or $Cu_2S/Zn_xCd_{1-x}S$ photovoltaic devices having improved stability can be made with CdS or $Zn_xCd_{1-x}S$ layer thicknesses less than 10 µm thick. The practice of this invention is immediately applicable to $CdS/Cu_2S$ cells of the back-wall type in which CdS is deposited by a pyrolytic spray process on glass which has been first coated with a transparent conductive oxide such as tin oxide. Photovoltaic devices of this type and others consisting essentially of amorphous silicon are described in published material by Photon Power Corporation and a publication by J. J. Hanak in Solar Energy, Vol. 23, pages 145—147 (1979), respectively. In these types of devices the semiconductor layers are deposited on a large area glass sheet. The semiconductor layers are then etched and interconnected in order to form a plurality of strip photovoltaic cells which are electrically connected in a photovoltaic module. It is recognized in the prior art that unless shunts and shorts are prevented, serious decreases in array efficiency and reliability could occur and may require discarding an entire array which can be as large as several square feet. The prior art has proposed the use of intermediate layers such as an $Al_2O_2$—CdS composite of U.S. Patent 4,159,914 in one case and cement buffer layer in another in order to prevent shorts and shunts. The present invention provides a superior means for increasing the yield and durability of these types of photovoltaic devices as well. In Figure 9 is shown a schematic diagram of an apparatus for practicing this invention when the substrate in a continuous manufacture process is a large glass sheet upon which a plurality of $Cu_2/CdS$ or amorphous silicon cells are to be formed and integrated. In connection with Figure 9, Figure 10 shows the photovoltaic structure where substrate 12A is a sheet of glass having a transparent oxide coating 13. The semiconductor layers of the cell CdS and $Cu_2S$ or amorphous silicon doped consecutively n-i-p are denoted as 15. A portion of transparent conductive oxide is exposed along a continuous edge 17. This may be accomplished by selectively depositing the semiconductor layers through a mask or by etching or mechanically removing semiconductor material. The manufacturing process involves moving the substrate on a carrier or rollers through the steps of semiconductor deposition and junction formation. After these steps have been completed and prior to metallization, temporary contact is made to the transparent conductive oxide and to the uppermost semiconductor layer. Contact to the transparent conductive oxide is made at exposed edge 17 by a wiper 46 which functions as contact 26 of Figure 4. Contact to the upper surface of semiconductor layers 15 is made by another wiper 48 which functions as contact 20 of Figure 4. Alternatively wiper 48 may be replaced by a contact roller (not shown) functioning as roller 38 of Figure 6 or 7. Laser beam 25 (Fig. 2) is scanned perpendicular to the direction of motion of substrate 12A. Shorts and shunting defects are located and removed in the inventive manner previously described. Since substrate 12A and oxide layer 13 are transparent, the laser beam for detecting and locating defects may be incident on the first uncoated surface of the substrate. Alternatively the laser beam may be situated to be incident directly upon the exposed surface of semiconductor layers 15. It is within the scope of this invention when practiced with transparent substrates that two laser beams may be used, one incident through the substrate and the second incident through the semiconductor layers. For example, a low powered laser beam used to locate defects and shorts would enter through the substrate and a high powered laser beam would be incident on the exposed semiconductor surface.

The invention has been further particularly described with respect to scanning a photovoltaic structure comprising substrate and semiconductor materials. The layered structure is incomplete as a photovoltaic device requiring application of a second permanent electrical contact such as a grid or transparent conductive oxide in the case of an opaque substrate or a continuous metal layer in the case of a transparent substrate. The scanning and defect elimination is done in a manner which necessarily could not damage the second electrical contact since the scanning and defect elimination is accomplished even before the grid structure is applied. It is to be understood, however, as previously indicated, that the invention may also be practiced with essentially complete photovoltaic devices having both first and second electrical contacts made and affixed thereto.

As is readily apparent, the above invention is particularly advantageous in its manner of precisely locating and then immediately eliminating any shunting defect. The invention is also particularly advantageous in that it lends itself to mass production techniques such as continuous manufacture of thin film photovoltaic devices. Accordingly the invention represents a significant advancement for increasing the durability and yield of such devices and may be readily applied to photovoltaic devices comprised of GaAs, or $Zn_3P_2$, or $CuInSe_2$, or polycrystalline silicon. As is further apparent, the above invention is advantageous in precisely locating and eliminating defects which affect the performance, yield and reliability of thin film semiconductor devices such as are useful for electrophotography, radiation detectors and optical displays.

## Claims

1. A method of manufacturing thin film photovoltaic cells wherein an electrical junction is formed between a pair of semiconductor layers mounted on a substrate with one of the semiconductor layers being adjacent the substrate and the other layer being remote from the substrate, a bias voltage being applied between the semiconductor layers, and wherein one of the semiconductor layers is laser scanned to locate any defects therein whereby a conductive contact provided on one side of that semiconductor layer would contact the other semiconductor layer through the defect which would result in a short, the defects being located by relating the x—y coordinate of the laser beam impact on the scanned semiconductor layer with the light-generated current flowing through the cell, characterized in that the applied bias voltage is a reverse bias voltage and that the defect causing such shorting is selectively eliminated by thermally burning out the defect.

2. In the method of claim 1 wherein the semiconductor layer being scanned is adjacent to the substrate.

3. In the method of claim 2 wherein the scanning and eliminating steps take place before a transparent electrical contact is applied to the remote semiconductor layer.

4. In the method of claim 1 wherein the defect eliminating step is done by applying an electrically conductive wire to the defect and applying current to the wire.

5. In the method of claim 1 wherein the defect eliminating step is done by applying a laser beam to the defect.

6. In the method of claim 5 wherein the same laser equipment is used for both the scanning and defect eliminating steps.

7. In the method of claim 6 wherein the scanning step is performed on the low power mode of the laser equipment, and the defect eliminating step is performed on the high power mode of the laser equipment.

8. In the method of claim 7 wherein the scanning step includes applying temporary wiper-type contacts against the remote semiconductor layer whereby the laser light-generated current is collected.

9. In the method of claim 8 wherein the scanning step includes applying temporary wiper-type contacts against the exposed component of the cell which is moved while the semiconductor layer is being scanned whereby the laser light-generated current is collected.

10. In the method of claim 1 wherein the semiconductor layers are oppositely doped regions of the same material.

11. Apparatus for the continuous manufacture of thin film photovoltaic cells according to the method of claim 1 wherein the apparatus includes a plurality of sequentially arranged stations for providing a substrate which functions as an opaque electrical contact, for applying a first semiconductor layer to the substrate, for applying a second semiconductor layer to the first semiconductor layer, for applying a bias voltage between the semiconductor layers, for selectively detecting shorting defects by laser scanning means and for applying a transparent electrical contact to the second semiconductor layer, characterized in that the bias voltage applying station is designed to apply reverse bias voltage and that the station for selectively detecting shorting defects includes thermal application means to selectively eliminate shorting defects by burning out.

12. In the apparatus of claim 11 wherein the laser means includes a low power mode and a high power mode whereby the same laser means functions to both detect and eliminate the defect.

13. In the apparatus of claim 12 wherein the laser means includes wiper-type contacts applied against the second semiconductor layer whereby the laser light-generated current is collected.

## Patentansprüche

1. Verfahren zur Herstellung von Dünnfilm-Photoelementen, bei welchem eine elektrische Verbindungsstelle zwischen zwei auf ein Substrat aufgebrachte Halbleiterschichten gebildet wird, wobei sich eine der Halbleiterschichten an dem Substrat angrenzt und die andere Schicht vom Substrat entfernt angeordnet ist, wobei eine Vorspannung zwischen den Halbleiterschichten angelegt wird, und wobei eine der Halbleiterschichten mit einem Laser abgetastet wird, um irgendwelche darin enthaltenen Fehlstellen zu orten, wodurch ein leitender Kontakt, der auf einer Seite dieser Halbleiterschicht vorgesehen ist, durch die Fehlstelle mit der anderen Halbleiterschicht in Kontakt käme und es so zu einem Kurzschluß käme, wobei die Fehlstellen dadurch geortet werden, daß die X—Y-Koordinate des Laserstrahlaufprallortes auf die abgetastete Halbleiterschicht mit dem durch die Zelle fließenden, durch Licht erzeugten Strom in Bezug gebracht wird, dadurch gekennzeichnet, daß die angelegte Vorspannung eine Sperr-Vorspannung ist, und daß die einen solchen Kurzschluß hervorrufende Fehlstelle selektiv durch thermisches Ausbrennen der Fehlstelle entfernt wird.

2. Verfahren nach Anspruch 1, bei dem die abgetastete Halbleiterschicht an das Substrat angrenzt.

3. Verfahren nach Anspruch 2, bei dem die Abtast- und Entfernungsschritte durchgeführt werden bevor ein transparenter elektrischer Kontakt auf die entfernt angeordnete Halbleiterschicht aufgebracht wird.

4. Verfahren nach Anspruch 1, bei dem der Schritt, mit welchem die Fehlstelle entfernt wird, dadurch ausgeführt wird, daß ein elektrisch leitender Draht an die Fehlstelle angelegt wird und Strom an den Draht angelegt wird.

5. Verfahren nach Anspruch 1, bei dem der Schritt, mit welchem die Fehlstelle entfernt wird, dadurch ausgeführt wird, daß ein Laserstrahl auf die Fehlstelle gerichtet wird.

6. Verfahren nach Anspruch 5, bei dem die gleiche Laservorrichtung sowohl für den Abtastschritt wie auch für den die Fehlstelle entfernenden Schritt verwendet wird.

7. Verfahren nach Anspruch 6, bei dem der Abtastschritt bei schwacher Leistung der Laservorrichtung und der die Fehlstelle entfernende Schritt im Hochleistungsbereich der Laservorrichtung durchgeführt wird.

8. Verfahren nach Anspruch 7, bei dem der Abtastschritt das vorübergehende Anlegen von wischerartigen Kontakten an die entfernt angeordnete Halbleiterschicht umfaßt, wodurch der durch Laser erzeugte Strom abgenommen wird.

9. Verfahren nach Anspruch 8, bei dem der Abtastschritt das vorübergehende Anlegen von wischerartigen Kontakten an den freiliegenden Teil der Zelle umfaßt, welche bewegt wird, während die Halbleiterschicht abgetastet wird, wodurch der durch Laserlicht erzeugte Strom abgenommen wird.

10. Verfahren nach Anspruch 1, bei dem die Halbleiterschichten entgegengesetzt dotierte Bereiche desselben Materials sind.

11. Vorrichtung für die kontinuierliche Herstellung von Dünnfilm-Photoelementen nach dem Verfahren von Anspruch 1, wobei die Vorrichtung eine Vielzahl von aufeinanderfolgend angeordneten Stationen umfaßt, um ein Substrat bereitzustellen, welches als lichtundurchlässiger elektrischer Kontakt wirkt, um eine erste Halbleiterschicht auf das Substrat aufzubringen, um eine zweite Halbleiterschicht auf die erste Halbleiterschicht aufzubringen, um eine Vorspannung zwischen den Halbleiterschichten anzulegen, um selektiv Kurzschluß-Fehlstellen durch Laserabtasteinrichtungen festzustellen, und um an die zweite Halbleiterschicht einen transparenten elektrischen Kontakt aufzubringen, dadurch gekennzeichnet, daß die die Vorspannung anlegende Station so ausgelegt ist, daß eine Sperr-Vorspannung angelegt wird, und daß die zur selektiven Feststellung von Kurzschluß-Fehlstellen vorgesehene Station Wärmeanwendungseinrichtungen umfaßt, um Kurzschluß-Fehlstellen selektiv durch Ausbrennen zu entfernen.

12. Vorrichtung nach Anspruch 11, bei welcher die Laservorrichtung eine mit schwacher Leistung arbeitende Betriebsart und eine Hochleistungsbetriebsart umfaßt, wodurch die gleiche Laservorrichtung sowohl für die Feststellung als auch für die Entfernung der Fehlstelle dient.

13. Vorrichtung nach Anspruch 12, bei welcher die Lasereinrichtung wischerartige Kontakte umfaßt, welche an die zweite Halbleiterschicht angelegt sind, wodurch der durch Laserlicht erzeugte Strom abgenommen wird.

**Revendications**

1. Procédé de fabrication de cellules photovoltaïques à film mince selon lequel on forme une jonction électrique entre deux couches semiconductrices fixées sur un substrat, l'une des couches semi-conductrices étant adjacente au substrat et l'autre couche éloignée du substrat, une tension de polarisation étant appliquée entre les couches semi-conductrices, et selon lequel l'une des couches semi-conductrice est balayée par un laser pour localiser tout défaut dans celle-ci par lequel un contact conducteur réalisé sur un côté de cette couche semi-conductrice entrerait en contact avec l'autre couche semi-conductrice à travers ce défaut, avec pour résultat un court-circuit, les défauts étant localisés en rapportant les coordonnées x—y de l'impact du faisceau laser sur la couche semi-conductrice balayée au courant engendré par la lumière et circulant à travers la cellule, caractérisé en ce que la tension de polarisation appliquée est une tension de polarisation inverse et en ce que le défaut provoquant un tel court-circuit est supprimé sélectivement par brûlage thermique de ce défaut.

2. Procédé suivant la revendication 1, selon lequel la couche semi-conductrice balayée est adjacente au substrat.

3. Procédé suivant la revendication 2, selon lequel les phases de balayage et de suppression sont effectuées avant qu'un contact électrique transparent soit appliqué sur la couche semiconductrice éloignée.

4. Procédé suivant la revendication 1, selon lequel la phase de suppression du défaut est effectuée en appliquant sur le défaut un fil métallique électriquement conducteur et en envoyant un courant dans ce fil.

5. Procédé suivant la revendication 1, selon lequel la phase de suppression du défaut est effectuée en appliquant un faisceau laser sur le défaut.

6. Procédé suivant la revendication 5, selon lequel on utilise le même appareil laser à la fois pour les phases de balayage et de suppression du défaut.

7. Procédé suivant la revendication 6, selon lequel la phase de balayage est effectuée dans le mode de fonctionnement à faible puissance de l'appareil laser et la phase de suppression du défaut est effectuée dans le mode à haute puissance de l'appareil laser.

8. Procédé suivant la revendication 7, selon lequel la phase de balayage comprend l'application contre la couche semi-conductrice éloignée de contacts temporaires du type balai par lesquels on recueille le courant engendré par la lumière du laser.

9. Procédé suivant la revendication 8, selon lequel la phase de balayage comprend l'application contre le composant exposé de la cellule qui se déplace tandis que la couche semi-conductrice est balayée de contacts temporaires du type balai sur lesquels on recueille le courant engendré par la lumière du laser.

10. Procédé suivant la revendication 1, selon lequel les couches semi-conductrices sont des régions du même matériau dopées en sens opposé.

11. Appareil pour la fabrication en continu de cellules photovoltaiques à film mince suivant le procédé de la revendication 1, dans lequel l'appareil comprend plusieurs postes disposés séquentiellement pour fournir un substrat qui agit en tant que contact électrique opaque, pour appliquer une première couche semi-conductrice sur le substrat, pour appliquer une seconde couche semi-conductrice sur la première couche semi-conductrice, pour appliquer une tension de polarisation entre les couches semi-conductrices, pour détecter sélectivement les défauts faisant court-circuit par un appareil de balayage à laser et pour appliquer un contact électrique transparent sur la seconde couche semi-conductrice, caractérisé en ce que le poste d'application de la tension de polarisation est conçu pour appliquer une tension de polarisation inverse et en ce que le poste pour détecter sélectivement des défauts faisant courts-circuits comprend un dispositif d'application thermique pour supprimer sélectivement par brûlage ces défauts faisant court-circuit.

12. Appareil suivant la revendication 11, dans lequel l'appareil à laser comporte un mode à basse puissance et un mode à haute puissance, grâce à quoi le même appareil à laser agit à la fois pour détecter et pour supprimer les défauts.

13. Appareil suivant la revendication 12, dans lequel l'appareil à laser comprend des contacts du type balai appliqués contre la seconde couche semi-conductrice, et par lesquels on recueille le courant engendré par la lumière du laser.

Fig.1.

Fig.2.

0 087 776

*Fig. 3.*

A   B   D   E

C

26

20

12

14   16

20

28

22

Substrate
Electrical Contact

Top
Electrical Contact

*Fig. 4.*

*Fig. 9.*

48   15   17   12

46   17

*Fig. 10.*

15   13

17

12A

Fig.5.

Fig.6.

36
38

Fig.7.

24
38
25
36

*Fig.8.*

```
┌─────────────────┐
│    Substrate    │
│    Formation    │
└────────┬────────┘
         ↓
┌─────────────────┐
│    Form First   │
│  Semiconductor  │
│   $Zn_X Cd_{1-X} S$  │
└────────┬────────┘
         ↓
┌─────────────────────┐
│    Form Second      │
│ Semiconductor $Cu_2 S$ │
└──────────┬──────────┘
           ↓
┌─────────────────┐
│  Form Junction  │
└────────┬────────┘
         ↓
┌─────────────────┐
│Defect Elimination│
└────────┬────────┘
         ↓
┌─────────────────┐
│    Complete     │
│     Device      │
└─────────────────┘
```